# EUROPEAN PATENT APPLICATION

(11) **EP 4 796 998 A1**
(43) Date of publication of application: **26.08.2026**
(21) Application number: 25159223.4
(22) Date of filing: 20.02.2025
(51) Int. Cl.: G03F 7/00, H01L 21/311, H01L 21/768, H01L 21/033

(54) **A PATTERNING METHOD APPLICABLE IN SEMICONDUCTOR PROCESSING**

(71) Applicant: Imec VZW, 3001 Leuven (BE)
(72) Inventor: Frommhold, Andreas, 3001 Heverlee (BE); Wiaux, Vincent, 1348 Louvain-la-Neuve (BE); Blanco, Victor M., 3061 Leefdaal (BE)
(74) Representative: Patent Department IMEC

(57) **Abstract**

A pattern is produced in a die area (25) of a layer (30,33) formed on a support substrate (32) by at least two process sequences, each comprising a lithography step and an etch step, performed in adjacent subportions of the die area. One or more parallel line shaped features (28) of the pattern extend from the first subportion (25a) of the die area to the second subportion (25b), i.e. across the border (27) between the die areas. Mutually aligned and spaced apart first and second parts of the line features are printed in the respective process sequence steps and transferred to the layer in the form of negative or positive pattern features in the patterned layer, i.e. in the form of trenches (28'a,28'b) in the layer or in the form of lines separated by mutually aligned trenches (37a;37b). In either case, directional etching is thereafter applied to stretch the aligned trenches and thereby obtain the desired line features (28) extending from one subportion of the die area to the other subportion.

## Description

### Field of the Invention

The present invention is related to semiconductor fabrication processes, in particular to patterning methods for producing line-shaped pattern features.

### State of the art.

Semiconductor fabrication processing relies on advanced lithography and etch technologies. Under particular conditions, for example for producing larger die sizes, chipmakers may be forced to print two parts of a chip in separate exposure steps. One part of the chip is exposed with one mask, the other part with a second mask. If the two parts comprise line features which cross from one part of the chip to the other, stitching between the parts is applied, which involves printing overlapping features in the transition zone between the printed chip parts.

This technique is however subject to errors in the feature dimensions due to a number of effects such as the absorber reflection and the influence of the absorber to black border transition. Complex compensation strategies are therefore being applied in the design stage in order to alleviate these problems. These strategies however increase the design time, cost and complexity.

### Summary of the invention

The invention is related to methods in accordance with the appended claims. According to the invention, stitching between adjacent parts of a chip design is realized by applying directional etching. A pattern is produced in a die area of a layer formed on a support substrate by at least two process sequences, each comprising a lithography step and an etch step, performed in adjacent subportions of the die area. One or more parallel line shaped features of the pattern extend from the first subportion of the die area to the second subportion, i.e. across the border between the die areas. Mutually aligned and spaced apart first and second parts of the line features are printed in the respective process sequence steps and transferred to the layer in the form of negative or positive pattern features in the patterned layer, i.e. in the form of trenches in the layer or in the form of lines separated by mutually aligned trenches. In either case, directional etching is thereafter applied to stretch the aligned trenches and thereby obtain the desired line features extending from one subportion of the die area to the other subportion.

The method enables printing adjacent parts of a pattern without overlapping pattern features, thereby avoiding most of the negative effects inherent to prior approaches to realize stitching between adjacent die areas.

The invention is in particular related to a patterning method applicable in a semiconductor production process, the method comprising the steps of :
- on a support substrate, producing a layer that is to be patterned according to a pre-defined pattern in a semiconductor die area of the layer,
- producing said pattern by at least two consecutive process sequences, each sequence comprising a lithographic exposure step configured to print a part of the pattern in a corresponding sub-portion of the die area, and wherein the pattern comprises one or more parallel line-shaped features configured to extend from a first subportion of the die area to a second sub-portion directly adjacent the first sub-portion,
   wherein :
- the lithographic exposure step for printing a first part of the pattern is configured to print first parts of the one or more line-shaped features,
- the lithographic exposure step for printing a second part of the pattern is configured to print second parts of the one or more line-shaped features,
characterized in that :
- the second parts of the one or more line-shaped features are aligned to and distanced from the first parts of the one or more line-shaped features, so that after performing the two process sequences and after transferring the first and second parts of the pattern to the layer, the layer is patterned according to a pattern including at least one pair of mutually aligned trenches,
- a directional etching process is applied by scanning an etch beam in a scanning direction parallel to the aligned trenches, to thereby merge the aligned trenches into a single trench.

According to an embodiment, the location of the trenches in the direction perpendicular to said trenches corresponds to the location of the line features of the pattern.

According to an embodiment, the location of the trenches in the direction perpendicular to said trenches corresponds to spaces between the line features of the pattern.

### Brief description of the figures

Figure 1 illustrates the main components of a tool suitable for directional etching.
Figures 2a and 2b illustrate the process of directional etching.
Figures 3a and 3b illustrate a distribution of die areas on a process wafer and a magnified image of one die area applicable in a method according to the invention.
Figures 4a to 4d illustrate a method in accordance with a first embodiment of the invention.
Figures 5a to 5d illustrate a method in accordance with a second embodiment of the invention.

### Detailed description of the invention

Basic principles and configurations for realizing directional patterning are for example described in patent publication document US10790155. According to the technology, a plasma beam is scanned relative to a substrate comprising a layer that is to be patterned. By tuning several parameters and conditions, it is possible to direct a plasma beam containing etch species so that the beam etches a layer on the wafer at a considerably higher etch rate in the scanning direction than in directions orthogonal to said scanning direction. This capability makes it possible to 'stretch' an existing opening in the layer by scanning a plasma beam across the opening.

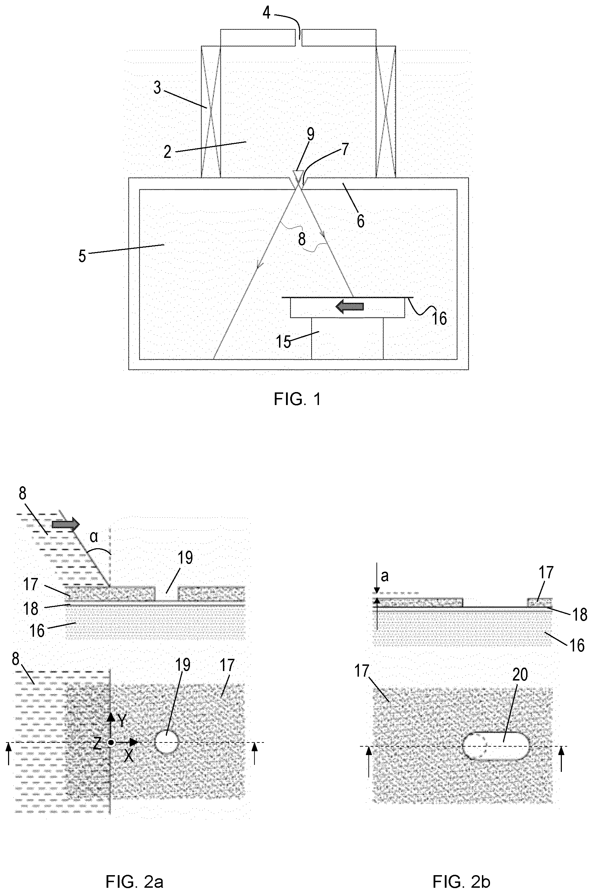

Figure 1 illustrates a process tool 1 for applying one particular directional etching technology that is presently known in the state of the art. The invention is however not limited to this technology. The tool comprises a plasma chamber 2 surrounded by an RF coil 3 for generating a plasma in the chamber. A gas inlet 4 enables supplying a gaseous substance, while the overall pressure in the plasma chamber is kept at very low to vacuum level by a suitable vacuum pump installation (not shown). The plasma chamber 2 is separated from a process chamber 5 by a separating wall 6 comprising a slit 7, so that ribbon plasma beams 8 are emitted from the slit. The process chamber is also at low to vacuum pressure. A meniscus 9 may be mounted in the vicinity of the slit 7 at a distance that can be set in order to control the propagation direction of the emitted beams 8. A wafer stage 15 is mounted in the process chamber 5. The wafer stage 15 is movable linearly as indicated by the arrow, so that a wafer 16 held by the wafer stage can be moved relative to one of the beams 8, thereby creating the equivalent of the beam 8 being scanned across the wafer 16.

As stated, other directional etching technologies are known and can be applied in the method according to the invention. Ion beam-based technologies include a method wherein a collimated beam of charged particles e.g. Ar⁺ is accelerated on a full wafer at a given angle of incidence. In the latter method, the wafer stage is not moving relative to the beam as the beam is impinging on the full wafer. According to another known ion beam-based technology, a collimated beam of ionized gas clusters is accelerated to a spot and scanned across a wafer surface at a given angle of incidence. In the latter two technologies, the angle of incidence of the beam is adjusted by tilting the wafer.

Figures 2a and 2b illustrate the directional etching effect on a layer 17 formed on the wafer 16. The layer 17 is produced on an etch stop layer 18. Before applying the directional etch process, an opening 19 is formed in the layer 17 by standard lithography and etching, for example by direct ion etching (DIE). A plasma beam 8 is generated and directed at an angle of incidence α, defined as the angle between the beam 8 and the direction perpendicular to the surface of the layer 17. By moving the wafer stage 15 in the direction indicated in Figure 1, the plasma beam 8 is scanned relative to the layer 17 in a scanning direction X. The angle β between the beam 8 and the scanning direction X is an oblique angle equal to 90°+α. By applying a suitable combination of etch parameters such as the RF power, a DC bias voltage connected to the separator plate 6 and/or the wafer stage 15, the applied etch species, the angle of incidence α and the scanning speed, scanning the beam across the opening 19 has the effect of stretching the opening in the scanning direction, as illustrated in Figure 2b. The directional etch process is selective with respect to the etch stop layer 18 so that this layer remains essentially intact and prohibits etching of the underlying support substrate 16. The etch rate in the X-direction is considerably higher than the etch rate in the Y and Z-directions. The result is therefore an elongation of the opening 19 in the X-direction to form a line-shaped trench 20. In the Y-direction the line may be slightly larger than the original hole diameter, due to the non-zero etch rate in the Y direction. Etching in the Z-direction causes thinning of the layer 17 by a layer thickness reduction a. A further elongation of the trench 20 can be realized by a repeated directional etch step in the same direction +X or in the opposite direction -X.

According to the invention, directional etching is applied for realizing stitching between adjacent parts of a pattern which have been obtained through separate lithographic exposures.

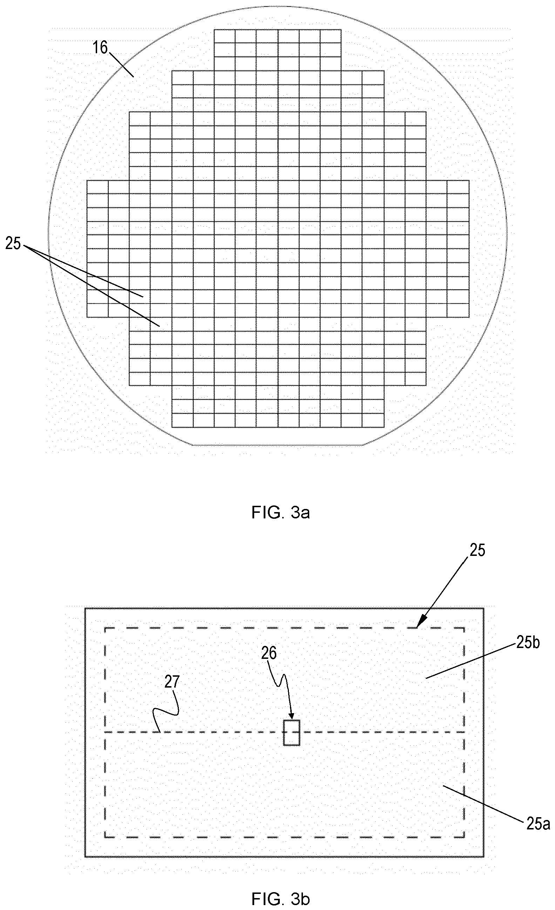

Figure 3a shows a process wafer 16 comprising a plurality of semiconductor die areas 25, i.e. areas on the wafer where a semiconductor die, such as an integrated circuit chip, is to be processed. At the end of the processing, the wafer is cut by a dicing tool to obtain the separate dies. A magnified view of one die area 25 is shown in Figure 3b. As known in the art, the die area is distanced apart from neighbouring die areas by a dicing lane to enable the eventual dicing operation. The die area 25 indicated by the dotted line is thus defined in the present context as the area onto which patterned layers are produced in the course of the fabrication process.

Said die area 25 is divided in two adjacent sub-portions 25a and 25b. Producing at least some of the various layers of the die requires two exposures through separate lithographic masks, one for each sub-portion of the die area. For example, a layer of the back-end-of-line stack of the die may comprise a pattern of line-shaped conductors which are to be produced by etching line-shaped trenches in a dielectric layer and filling said trenches with a metal.

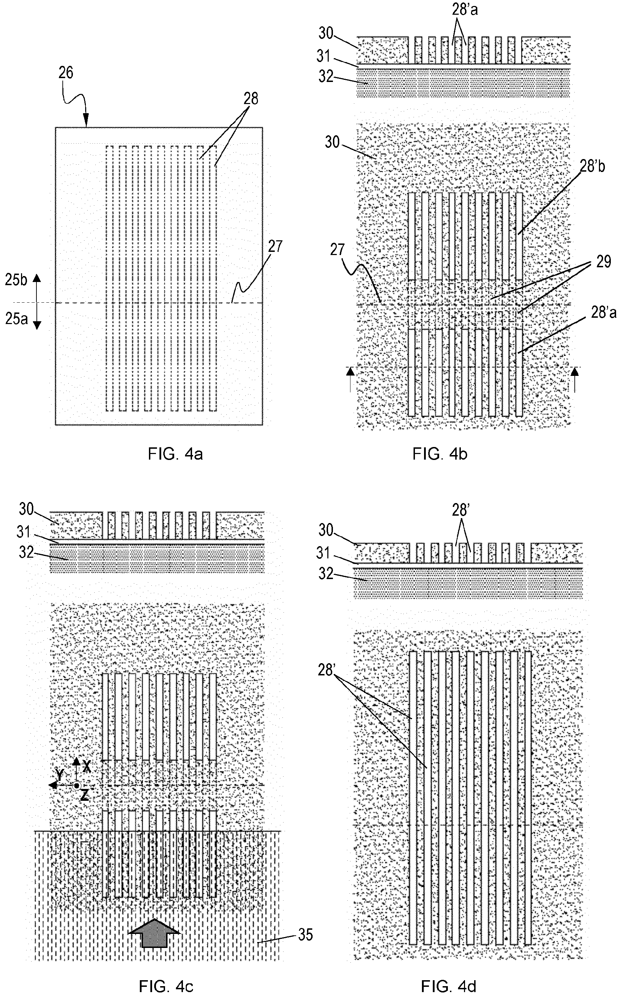

Reference is made to Figure 4a which shows a magnified image of the rectangular area 26 indicated in Figure 3b. The rectangular area overlaps the border 27 between the two sub-portions 25a,25b of the die area 25. The image in Figure 4a also shows the pattern comprising a number of parallel line shaped conductors 28, that is to be produced in this rectangular area. The lines are perpendicular to the border 27 between the subportions 25a,25b of the die area and extend from one subportion 25a to the other subportion 25b, across said border 27.

The invention provides a novel way of realizing this pattern. Figure 4b shows the patterns which are realized in the two sub-portions 25a,25b of the die area 25, by respective process sequences, each comprising a lithography step and an etch step. The patterns are produced in a dielectric layer 30 that is formed on top of an etch stop layer 31. The etch stop layer lies on a support layer 32 which may for example be a previously processed layer of a BEOL stack of an integrated circuit processed on the wafer 16 illustrated in Figure 3a.

The lithographic masks applied in the two process sequences are configured to print respective first and second parts of the intended line-shaped features 28, wherein the first and second line parts are mutually aligned. The lithography step applied in each sequence may for example include forming a positive tone photoresist layer on the dielectric layer 30, exposing the resist to UV light through a mask that blocks the UV-light except at the line features, and developing the resist, thereby leaving a pattern of trenches in the resist layer corresponding to the location of the line parts. The trenches are transferred by anisotropic etching to the dielectric layer 30, leading to the formation of corresponding trenches 28'a,28'b in said layer 30, as illustrated in Figure 4b.

The pattern obtained thus comprises pairs of mutually aligned trenches 28'a,28'b, with a portion 29 of the layer material separating the trenches of each pair across the border 27 between the subportions 25a,25b of the die area 25.

The portions 29 are thereafter removed by a directional etch process that is selective with respect to the etch stop layer 31. The directional etch step is illustrated in Figure 4c. The plasma beam 35 is scanned in the +X direction indicated by the arrow, i.e. parallel to the trenches 28'a,28'b and configured to remove the material 29 between the abutting tips of the aligned trenches, to thereby merge the trenches and obtain continuous trenches 28' passing from the first subportion 25a to the second subportion 25b of the die area, as illustrated in Figure 4d. The thickness of the dielectric layer 30 decreases due to a certain etch rate in the Z-direction. The effect of a possible small etch rate in the Y direction perpendicular to the trenches is not represented in the drawing but could lead to a small increase of the width of the trenches after the directional etch process. This effect can be taken into account in the design stage of the masks.

It is seen that the etch beam 35 not only removes the intermediate material 29 between the abutting trenches 28'a,28'b but that the beam also elongates the trenches 28'b onto which the beam impinges after removing said intermediate material. This is inherent to the directional etch process. In designing the masks for the two lithography steps described above, this effect is taken into account, i.e. the length of the line parts reproduced as trenches 28'a and 28'b is designed such that after the merging of the trenches, the length of the merged trenches corresponds to the required length of the corresponding line features.

In the previous embodiment, the location in the Y-direction of the trenches 28'a/28'b formed in the dielectric layer 30 corresponds to the location of the eventual line-shaped features 28 of the pattern, i.e. the directional etching is applied to stretch existing trenches, i.e. 'negative' features in a layer. The invention is however also applicable when the trenches correspond to the spaces between 'positive' features.

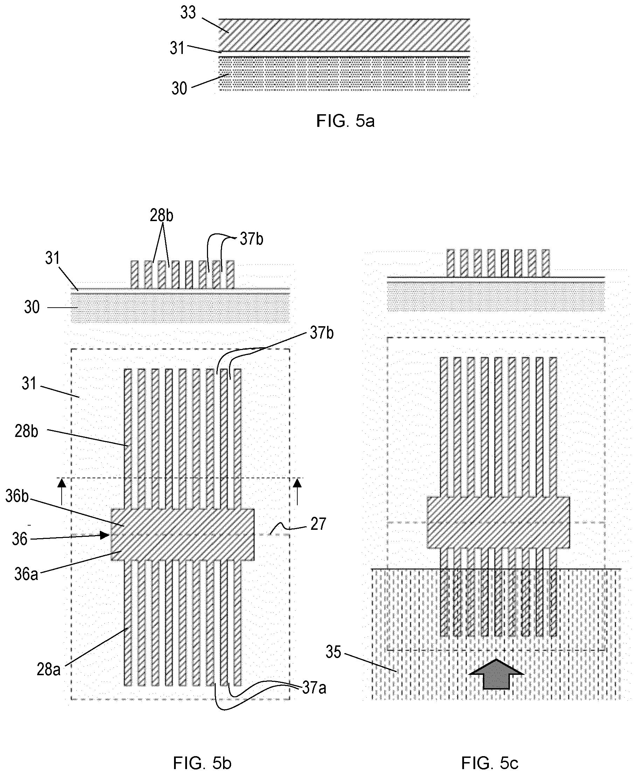

Figures 5a-5d illustrate an embodiment wherein the respective line patterns in the first and second subportion 25a,25b of the die area 25 are produced as positive line patterns, for example as metal lines obtained by patterning a metal layer 33 formed on the etch stop layer 31 (Figure 5a). With reference to Figure 5b, the line patterns as produced in the respective process sequences applied in the two die areas 25a and 25b include the lines 28a,28b and respective blocks 36a,36b of the metal layer which together form a metal area 36 that crosses the border 27 between the subportions 25a,25b of the die area 25.

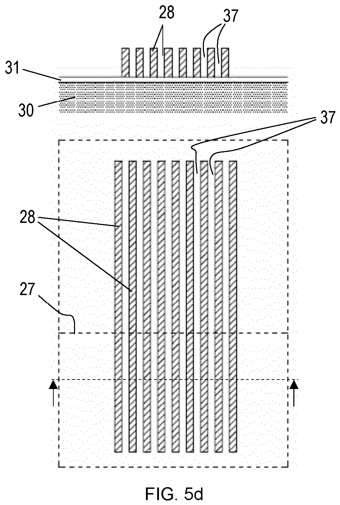

This means that mutually aligned trenches 37a,37b are now formed between the positively defined line features 28a,28b. With reference to Figure 5c, directional etching is applied by scanning a plasma etch beam 35 using the same scanning direction +X as in the previous embodiment. The directional etch process now removes the metal in the solid metal area 36 in the direction of the trenches, i.e. the trenches 37a and 37b merge to form continuous trenches 37, so that the continuous line features 28 are obtained, as illustrated in Figure 5d. In view of the scanning direction of the beam, the lines 28a are likely to be shortened by this directional etch process, therefore (as shown in Figure 5b), the lithographic mask for printing the pattern part in the first die area 25a is configured to print a longer line length 28a compared to the design length, so that after directional etching, the required line length of the lines 28 is obtained.

## Claims

1. A patterning method applicable in a semiconductor production process, the method comprising the steps of :
- on a support substrate (32), producing a layer (30,33) that is to be patterned according to a pre-defined pattern in a semiconductor die area (25) of the layer,
- producing said pattern by at least two consecutive process sequences, each sequence comprising a lithographic exposure step configured to print a part of the pattern in a corresponding sub-portion (25a,25b) of the die area, and wherein the pattern comprises one or more parallel line-shaped features (28) configured to extend from a first subportion (25a) of the die area (25) to a second sub-portion (25b) directly adjacent the first sub-portion,
wherein :
- the lithographic exposure step for printing a first part of the pattern is configured to print first parts (28a,28'a) of the one or more line-shaped features,
- the lithographic exposure step for printing a second part of the pattern is configured to print second parts (28b,28'b) of the one or more line-shaped features,
**characterized in that** :
- the second parts (28b,28'b) of the one or more line-shaped features are aligned to and distanced from the first parts (28a,28'a) of the one or more line-shaped features, so that after performing the two process sequences and after transferring the first and second parts of the pattern to the layer (30,33), the layer is patterned according to a pattern including at least one pair of mutually aligned trenches (28'a,28'b;37a,37b)
- a directional etching process is applied by scanning an etch beam (35) in a scanning direction parallel to the aligned trenches, to thereby merge the aligned trenches into a single trench (28,37).

2. The method according to claim 1, wherein the location of the trenches (28'a,28'b) in the direction perpendicular to said trenches corresponds to the location of the line features (28) of the pattern.

3. The method according to claim 1, wherein the location of the trenches (37a,37b) in the direction perpendicular to said trenches corresponds to spaces between the line features (28) of the pattern.
